# DEMANDE DE BREVET EUROPEEN

(11) **EP 2 624 394 A1**
(43) Date de publication de la demande: **07.08.2013**
(21) Numéro de dépôt: 13153197.2
(22) Date de dépôt: 30.01.2013
(51) Int. Cl.: H02G 13/00, G01R 27/20, G01R 31/02, H01R 4/66, H02G 9/02

(54) **Dispositif et procédé de contrôle de la pérennité du réseau de terre contre la foudre**

(30) Priorité: 03.02.2012 FR 1251017
(71) Demandeur: GRTGAZ, 92270 Bois Colombes (FR)
(72) Inventeur: Henry, Laurent, 60400 NAMPCEL (FR)
(74) Mandataire: Garcia, Christine

(57) **Abrégé**

La présente invention concerne un dispositif (10) de contrôle de la pérennité du réseau de terre contre la foudre constitué d'un câble en acier galvanisé d'une longueur de 1,3 mètre et d'une section de 95 mm², la section du câble effectivement en contact avec le sol étant de 1 mètre.

L'invention concerne également le procédé de mise en place du dispositif de contrôle de la pérennité du réseau de terre (20, 21, 22, 23, 41, 42, 30, 102) contre la foudre. Ce procédé consiste à déterminer des zones de positionnement du dispositif dans le sol et à enfouir le dispositif dans le sol (100, 101) au niveau des zones déterminées.

Ces zones déterminées sont :
- au moins une zone avec une protection cathodique satisfaisante
- au moins une zone à creux de potentiel,
- au moins une zone à risque de surprotection cathodique.

## Description

La présente invention concerne le domaine du contrôle de la pérennité du réseau de mise à la terre contre la foudre, et plus particulièrement un dispositif et un procédé de contrôle de pérennité de réseau de terre contre la foudre.

La foudre se comporte comme un générateur parfait de courant. Une des méthodes de protection contre la foudre est donc de faciliter la circulation des charges électriques vers la terre au moyen de conducteurs non fonctionnels. Pour cela, en général, on utilise le dispositif extérieur de protection d'une installation contre la foudre constituée d'un réseau de conducteurs nus et enterrés et de prises de terre. Cet ensemble est en contact intime avec le sol et doit permettre de disperser les courants dans le sol. Pour ce faire, ces conducteurs doivent présenter une faible résistance, afin de guider la foudre vers le sol et ainsi limiter les surtensions susceptibles d'apparaître sur les liaisons électriques extérieures qui pénètrent dans l'installation à protéger. Cet ensemble de conducteurs doit être interconnecté correctement et durablement.

Le dimensionnement d'un dispositif extérieur de protection contre la foudre est régi en France par les normes NF EN 62 305 et NF C 17-100. Ces normes proposent une méthode d'analyse de risque à partir de paramètres tels que la sensibilité de l'installation à protéger (présence de matières dangereuses, risque de panique...) et son exposition au phénomène de la foudre, estimée à partir de statistiques de foudroiement de la zone géographique dans laquelle l'installation à protéger se situe. Cette analyse aboutit à la détermination d'un niveau de protection à apporter, à partir duquel la norme propose un dimensionnement adéquat du dispositif extérieur de protection de l'installation.

Les installations dites « à risques industriels » sont soumises à des vérifications de la pérennité du réseau de terre en acier galvanisé enterré et sujet à la corrosion. Ce réseau permet de protéger le personnel et les installations industrielles. Ces vérifications se font par un contrôle visuel au niveau d'excavations réalisées à proximité des installations sous contrôle.

Pour répondre à la réglementation, il est actuellement nécessaire de référencer jusqu'à cinquante points d'excavation environ, répartis sur un programme renouvelable tous les cinq ans : cela conduit l'exploitant à excaver une dizaine de ces points par an pour avoir une image du vieillissement du réseau de terre. En cas de rupture constatée, des moyens doivent être mis en oeuvre dans le but de rétablir les continuités électriques.

Ces nombreuses excavations réalisées pour un contrôle visuel augmentent le risque d'endommagement des ouvrages enterrés, mobilisent des ressources et génèrent des coûts d'exploitation importants.

La présente invention a donc pour objet de pallier un ou plusieurs des inconvénients de l'art antérieur en proposant un dispositif et un procédé ayant pour objectif de faire un suivi particulier de l'efficacité de la protection contre les effets de foudre sur un réseau en acier galvanisé maillé, sans réaliser d'excavations régulières.

Pour cela, la présente invention concerne un dispositif de contrôle de la pérennité du réseau de terre contre la foudre caractérisé en ce qu'il comporte un câble en acier galvanisé.

Selon un mode de réalisation de l'invention, le câble a une section de 95 mm² plus ou moins les tolérances de fabrication et une longueur de 1,3 mètre plus ou moins 1 cm, la partie en contact avec le sol ayant une longueur de 1 mètre.

La valeur de 1 mètre est un compromis entre une longueur de câble suffisante pour obtenir une mesure correcte dans le sol et un calcul, de l'efficacité du réseau, simplifié. On obtient ainsi un résultat fiable et facilement interprétable.

Selon un mode de réalisation de l'invention, le câble comporte un capuchon thermo-rétractable à chacune de ses extrémités.

Ce capuchon permet de protéger les extrémités du câble et d'obtenir la longueur voulue de contact avec le sol.

Selon un autre aspect, la présente invention concerne un procédé de mise en place du dispositif de contrôle de la pérennité du réseau de terre contre la foudre consistant à :
- déterminer des zones de positionnement du dispositif dans le sol,
- enfouir le dispositif dans le sol au niveau des zones déterminées.

Les zones de positionnement du dispositif sont importantes et doivent couvrir différents domaines de protection contre la corrosion. Il est possible d'avoir une vue d'ensemble de l'état du réseau de mise à la terre.

Selon un mode de réalisation de l'invention, la détermination des zones se fait par mesure du potentiel à courant coupé (Eoff) permettant de déterminer l'efficacité de la protection cathodique du réseau de terre.

Selon un mode de réalisation de l'invention, les zones, d'installations des dispositifs, déterminées sont les suivantes :
- au moins une zone avec une protection cathodique satisfaisante avec un potentiel à courant coupé (Eoff) compris entre -900 mV et -1500mV ,
- au moins une zone à creux de potentiel, avec potentiel à courant coupé (Eoff) supérieur à -900 mV,
- au moins une zone à risque de surprotection cathodique, avec un potentiel à courant coupé (Eoff) inférieur à -1500mV.

De cette façon tous les types de zones sont couverts par les témoins foudre : du plus protégé au moins protégé, en terme de corrosion.

Les valeurs de potentiel à courant coupé permettent d'affiner la position des témoins foudre, et rendent ainsi le procédé plus performant.

Selon un mode de réalisation de l'invention, on détermine au moins deux zones à creux de potentiel.

Selon un mode de réalisation de l'invention,
- on met en place le dispositif à au moins 0,5 m du câble de terre,
- on soude un câble de protection cathodique sur le réseau de terre et sur le dispositif,
- sur chaque extrémité du dispositif on dispose un capuchon thermo-rétractable pour obtenir une longueur effective de câble en contact avec le sol de 1,00 m,
- On rétreint les capuchons thermo-rétractables avec une source de chaleur compatible avec le manchon,
- On pose un coffret de mesure à proximité de la liaison du dispositif,
- On connecte les deux extrémités des câbles de protection cathodique sur une platine sécurisée dans ce coffret de mesure,
- On met des shunts de liaison sur la platine dans le coffret entre le dispositif et le réseau de terre afin de mettre sous protection cathodique le témoin foudre.

D'autres buts, caractéristiques et avantages de l'invention seront mieux compris et apparaîtront plus clairement à la lecture de la description faite, ci-après, en se référant aux figures annexées et données à titre d'exemple :
- la figure 1 est une représentation schématique d'un mode de réalisation du dispositif selon l'invention,
- la figure 2 est une représentation schématique d'une mise en oeuvre du dispositif selon l'invention,
- la figure 3 est une représentation schématique du procédé selon l'invention.

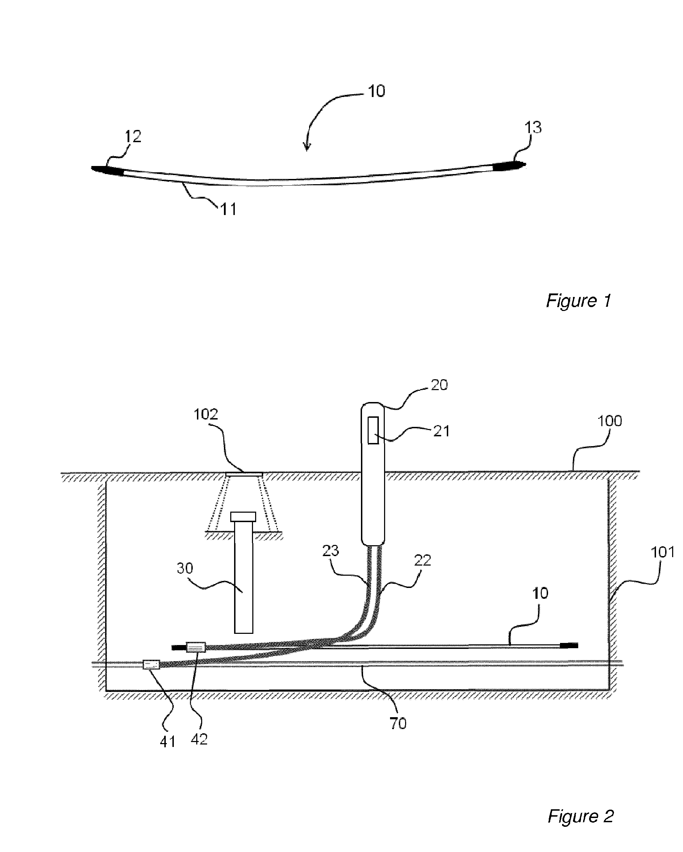

Selon un premier aspect illustré sur la figure 1, la présente invention concerne un dispositif (10) permettant de contrôler la pérennité des installations de protection contre la foudre. Ce dispositif (10) est également appelé témoin foudre.

Les installations de protection contre la foudre concernées par la présente invention sont de type protection cathodique, maillage enterré et prises de terre.

La protection cathodique permet de protéger un métal contre la corrosion. Pour modifier le potentiel du métal à protéger cathodiquement, une anode installée dans le même électrolyte est utilisée. Les anodes peuvent être de deux types : soit des anodes ayant un potentiel plus électronégatif que le métal à protéger (anode sacrificielle), soit des anodes couplées à un générateur de tension continue imposant une différence de potentiel entre les deux métaux (méthode à courant imposé).

Le témoin foudre (10) est constitué d'un câble (11) en acier galvanisé sans gaine. La longueur du câble est de 1,3 mètre linéaire à + ou - 1 cm et de préférence est de 1,3 mètre. La section du câble est de 95mm² + ou - la tolérance constructeur, et de préférence est de 95 mm². Cette longueur de 1 mètre est choisie, d'une part pour permettre une mesure efficace dans le sol (le câble n'est ainsi ni trop long, ce qui évite par exemple qu'il ne s'emmêle, ni trop court, ce qui évite une trop faible surface de contact avec le sol), et d'autre part pour faciliter ensuite les calculs. Par exemple avec un courant de protection cathodique de 5 mA par mètre linéaire, les calculs sont simplifiés si le câble a une longueur de 1 mètre linéaire.

Ce câble est du même type que celui utilisé en général pour le réseau de terre et les prises de terre de type B (Selon la norme NEMA 5-15 / CS22.2, Nº42, cette prise comporte deux broches planes parallèles ainsi qu'une broche ronde de mise à la terre). Le câble (11) comporte à chacune de ses extrémités un capuchon thermo-rétractable (12, 13) pour que la longueur effective de câble nu atteigne 1,00 m. Lors de la mise en place du témoin foudre, ces capuchons sont rétreints. Ces capuchons évitent aux extrémités du câble de s'effilocher avec des intrusions de terre, ce qui a pour effet d'augmenter la section apparente du câble. Par exemple, le câble du témoin foudre a une longueur de 1,3m, les manchons ont une longueur de 0,05 mètre et la boite de jonction une longueur de 0,2m. Il reste ainsi 1 mètre de câble en contact avec le sol.

Comme illustré sur la figure 2, le témoin foudre (10) est enfoui dans le sol (100) dans une tranchée (101) au niveau du maillage de protection principale que l'on cherche à contrôler. Pour cela, il est posé en dérivation sur le réseau de terre (70).

A partir d'un plan de cheminement du maillage de mise à la terre et de mesures de l'efficacité de la protection cathodique, une sélection d'emplacements pour les témoins foudre est réalisée.

Dans le cadre de l'invention, afin de couvrir différents domaines de protection contre la corrosion, les témoins foudre sont installés dans les zones suivantes :
- Au moins un témoin foudre est installé dans une zone avec une protection cathodique satisfaisante, avec une bonne polarisation du maillage foudre. Dans cette zone le potentiel à courant coupé (Eoff) doit être comprise entre - 900 mV et -1500mV.
- Au moins un témoin foudre est installé dans une zone à creux de potentiel, avec une faible polarisation du maillage foudre (manque de protection). Dans cette zone le potentiel à courant coupé (Eoff) doit être supérieure à -900 mV.
- Au moins un témoin foudre est installé dans une zone à risque de surprotection cathodique, avec une bonne polarisation mais avec un risque de surprotection du maillage foudre. Dans cette zone le potentiel à courant coupé (Eoff) doit être inférieure à -1500mV.

De cette façon tous les types de zones sont couverts par les témoins foudre : du plus protégé au moins protégé, en terme de corrosion.

Lors de la mise en place du témoin foudre sur les zones déterminées il est ainsi possible de faire un point zéro sur le niveau d'oxydation ou non du câble de terre dans l'état de fonctionnement normal de la protection cathodique :
- En cas de corrosion sévère du câble de terre, pour être en conformité, la portion de câble incriminée est remplacée. Une action corrective de la protection cathodique est également étudiée.
- En cas d'immunité du câble de terre, le témoin foudre est installé, puis mis en service et les valeurs relevées sont archivées.
- Sur les installations neuves, les témoins sont mis en place dès la phase de construction.

Sur chaque lieu déterminé d'une installation existante, la mise en place des témoins foudre est réalisée de la façon suivante.

On réalise une excavation pour mettre au jour et localiser précisément le câble de terre. L'excavation est ensuite élargie pour que la tranchée atteigne des dimensions déterminées et par exemple : 0,5 m x 1,5 m.

Le témoin foudre est ensuite mis en place en tenant compte d'un éloignement minimum par rapport au câble de terre (70), et par exemple un éloignement minimum d'au moins 0,5 m.

Un câble de protection cathodique de 35mm² est soudé sur le réseau de terre. Un câble de protection cathodique est également soudé sur le témoin foudre. Les deux câbles (22, 23) de protection cathodique sont de section 35 mm² et sont soudés par un procédé aluminothermique. Il est en général nécessaire que les connexions de ces deux câbles de protection cathodique (22, 23) soient protégées. Pour cela, elles doivent être isolées par des boites de connexion étanches (41, 42).

Sur chaque extrémité du témoin foudre on dispose un capuchon thermo-rétractable (12, 13) de façon à ce que la longueur effective de câble nu atteigne par exemple 1,00 m. Ces capuchons thermo-rétractables sont ensuite rétreints à partir d'une source de chaleur admissible par le manchon.

Afin de différencier les câbles de protection cathodique pour ensuite, par exemple, faciliter les mesures, chacun des câbles de protection cathodique est identifié par le nom du câble auquel il est associé. Par exemple, le câble de protection de témoin foudre est repéré par « TEMOIN » par un système permanent et apparent. Le câble de protection cathodique du câble de terre du réseau de terre est repéré par « FOUDRE » par un système permanent et apparent.

On pose un coffret (20) de mesure à proximité de la liaison du témoin foudre. Les deux extrémités des câbles de protection cathodique sont connectées sur une platine (21) sécurisée dans ce coffret (20) de mesure.

Lorsque l'installation du témoin est terminée, on remet le terrain en l'état afin d'avoir le même environnement sur le réseau de terre et le témoin foudre (sable de même granulométrie, etc.). On compacte le terrain et on évacue les excédents.

On met des shunts de liaison sur la platine dans le coffret entre le témoin foudre et le réseau de terre afin de mettre sous protection cathodique le témoin foudre.

On positionne un fourreau (30) au dessus du témoin afin de descendre une électrode de mesure lors des contrôles. L'extrémité du fourreau (30) doit être à une distance ne devant pas excéder 5 cm + ou - 1 cm du témoin de foudre (10). On protège ce fourreau par une bouche à clé (102).

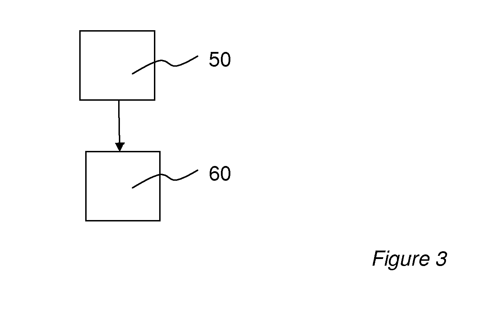

La présente invention concerne ainsi, selon un deuxième aspect illustré sur la figure 3, un procédé optimisé de positionnement de témoins foudre (10) dans le sol (100). Le positionnement de ces témoins permet une surveillance et un contrôle du réseau de terre (70) et des installations associées. Le contrôle est facilité par le fait qu'il ne nécessite pas de réaliser des excavations pour vérifier la pérennité du réseau de terre contre la foudre. Le procédé consiste ainsi à :
- déterminer (50) des zones de positionnement du dispositif (10) dans le sol, cette détermination pouvant être réalisée par mesure de l'efficacité de la protection cathodique du réseau de terre,
- enfouir (60) le dispositif dans le sol au niveau des zones déterminées, cette étape pouvant être réalisée par le procédé décrit ci-dessous.

Afin d'optimiser le positionnement des témoins foudre et permettre ainsi un meilleur contrôle de la pérennité du réseau de terre, on choisit :
- au moins une zone avec une protection cathodique satisfaisante,
- au moins une zone à creux de potentiel,
- au moins une zone à risque de surprotection cathodique.

Lorsque les témoins foudre sont installés, le contrôle de la pérennité du réseau est réalisé par des mesures de courant de protection cathodique permettant d'évaluer le risque de corrosion sur ces témoins, et donc sur le câble de terre.

Pratiquement, une mesure de potentiel réalisée après avoir descendu une électrode de mesure dans le fourreau (30) et une mesure de courant à partir de la platine de mesure permettent d'évaluer simplement le risque de corrosion sur ces témoins. En raison du positionnement des témoins, il est possible de déterminer par ces mesures, le risque de corrosion sur l'ensemble du réseau de terre. Si ce risque est nul, cela signifie que le réseau de terre est intègre comme l'exige la réglementation.

Les valeurs retenues pour déterminer l'efficacité de la protection du réseau de terre sont les suivantes :
- Si l'intensité (I) est inférieure à 0 mA : Le résultat de la mesure est jugé non satisfaisant. Une action corrective par renforcement de la protection cathodique peut être engagée.
- Si l'intensité (I) est supérieure à 5mA et si le potentiel à courant coupé (Eoff) est inférieure à -1500mV : Il y a risque de surprotection. Il faut alors prévoir une diminution de la protection cathodique.
- Si l'intensité (I) est comprise entre 0mA et 5mA et si le potentiel à courant coupé (Eoff) est inférieure à -1200mV, la situation est satisfaisante.
- Si l'intensité (I) est comprise entre 0mA et 5mA et si le potentiel à courant coupé (Eoff) est supérieure à -900 mV, le résultat de la mesure est non satisfaisant. Il faut alors augmenter le niveau de protection ou réaliser une étude de renforcement de la protection cathodique.

La mise en oeuvre de témoin foudre permet ainsi de répondre aux exigences réglementaires tout en réduisant le coût des opérations d'exploitation et surtout en diminuant considérablement le risque d'accrochage des ouvrages enterrés lors de terrassements de contrôles.

### Exemple de mise en oeuvre:

Cet exemple illustre la détermination de la position des témoins foudre sur un site ayant les caractéristiques suivantes (dans les tableaux suivants : PM signifie point de mesure, suivie de son numéro de référencement et du lieu du point de mesure): Le tableau 1 suivant représente l'ensemble des points de mesures effectués sur site étudié afin de déterminer les zones d'implantation des témoins foudre.

**Tableau 1**

| Référence de l'ouvrage | Potentiel à courant enclenché (Eon) de l'ouvrage/ électrode de surface en mV | Potentiel à courant coupé (Eoff) de l'ouvrage par rapport à l'électrode de surface en mV |
|---|---|---|
| PM-S-007-ROB1101 HV106-G | -1895.0 | -1075.0 |
| PM-S-008-ROB2001HV17-1-G | -725.0 | -660.0 |
| PM-S-009-ROB3102HV80-G | -1330.0 | -1000.0 |
| PM-S-010-ROB2001 HV21-G | -1240.0 | -970.0 |
| PM-S-011-ROB1101MV53-G | -1440.0 | -1040.0 |
| PM-S-012-ROB1102MV65-G | -1480.0 | -960.0 |
| PM-S-013-ROB1102HV106-2-G | -1070.0 | -850.0 |
| PM-S-014-ROB2002P123-2-G | -930.0 | -810.0 |
| PM-S-015-ROB3102HV81-G | -1160.0 | -900.0 |
| PM-S-016-ROB2002HV21-2-G | -1270.0 | -970.0 |
| PM-S-017-ROB1102MV53-G | -1360.0 | -1010.0 |
| PM-S-018-ROB2200HV46-G | -1075.0 | -800.0 |
| PM-S-019-ROB1103MV65-G | -1170.0 | -930.0 |
| PM-S-020-ROB1103HV106-3-G | -1150.0 | -980.0 |
| PM-S-022-ROB3102HV82-G | -1265.0 | -950.0 |
| PM-S-023-ROB3102HV47-G | -1050.0 | -915.0 |
| PM-S-024-ROB1103MV53-G | -1605.0 | -1000.0 |
| PM-S-025-ROB4000HV11-G | -1410.0 | -1080.0 |
| PM-S-026-ROB4126HV3-G | -850.0 | -580.0 |
| PM-S-027-ROB4126HV2-G | -760.0 | -570.0 |
| PM-S-028-EVENTEGOUT-G | -5860.0 | -1330.0 |
| PM-S-029-EVENTCOND-G | -1710.0 | -720.0 |
| PM-S-030-EVENTGAZOIL-G | -2465.0 | -930.0 |
| PM-S-031-dep air-G | -1300.0 | -990.0 |
| PM-S-032-DETCHAUENT-G | -1280.0 | -780.0 |
| PM-S-033-DETCHAUCAP-G | -1220.0 | -770.0 |
| PM-S-034-DETPRINCIP-G | -5190.0 | -1550.0 |
| PM-S-035-ZONEEVEVENT-G | -915.0 | -740.0 |
| PM-S-036-SEPARATEUR-G | -2510.0 | -1080.0 |
| PM-S-037-BJPJ01-G | -1070.0 | -750.0 |
| PM-S-038-BJPJ02-G | -1320.0 | -1000.0 |
| PM-S-040-BJPJ03-G | -1375.0 | -960.0 |
| PM-S-041-ANGLEDAMB-G | -2320.0 | -1080.0 |
| PM-S-042-BJPJ05-G | -1470.0 | -1080.0 |
| PM-S-043-ANGLE-G | -1230.0 | -1030.0 |
| PM-S-044-PARKING-G | -2080.0 | -1200.0 |
| PM-S-045-VELAENTSTA-A | -2335.0 | -990.0 |
| PM-S-046-DAMBENTSTA-A | -2490.0 | -1220.0 |
| PM-S-047-ROBHVB-G | -2000.0 | -1110.0 |
| PM-S-048-ROBMV20-G | -1810.0 | -1110.0 |
| PM-S-049-ROBVLV-G | -1600.0 | -1170.0 |
| PM-S-050-ROB VEV-G | -1700.0 | -1180.0 |
| PM-S-051-ROB VLE-G | -1425.0 | -1140.0 |
| PM-S-054-ROB VDA2-G | -1970.0 | -1100.0 |
| PM-S-055-ROB VED-G | -1660.0 | -1120.0 |
| PM-S-056-ROB VLD-G | -1780.0 | -1080.0 |

Les emplacements retenus sont dans les zones où sont situés les équipements suivants :
1- avec une protection cathodique satisfaisantes (tableau 2),( -900 mV<Eoff<-1500mV).

**Tableau 2**

| Référence de l'ouvrage | Potentiel à courant enclenché (Eon) de l'ouvrage/ électrode de surface en mV | Potentiel à courant coupé (Eoff) de l'ouvrage par rapport à l'électrode de surface en mV |
|---|---|---|
| PM-S-024-ROB1103MV53-G | -1605.0 | -1000.0 |

2- à creux de potentiel (manque de protection) (tableau 3), (Eoff>-900 mV).

**Tableau 3**

| Référence de l'ouvrage | Potentiel à courant enclenché (Eon) de l'ouvrage/ électrode de surface en mV | Potentiel à courant coupé (Eoff) de l'ouvrage par rapport à l'électrode de surface en mV |
|---|---|---|
| PM-S-014-ROB2002PI23-2-G | -930.0 | -810.0 |

3- à risque de surprotection cathodique (tableau 4) , (Eoff<-1500mV).

**Tableau 4**

| Référence de l'ouvrage | Potentiel à courant enclenché (Eon) de l'ouvrage/ électrode de surface en mV | Potentiel à courant coupé (Eoff) de l'ouvrage par rapport à l'électrode de surface en mV |
|---|---|---|
| PM-S-034-VOI-DETPRINCIP-G | -5190.0 | -1550.0 |

La portée de la présente invention ne se limite pas aux détails donnés ci-dessus et permet des modes de réalisation sous de nombreuses autres formes spécifiques sans s'éloigner du domaine d'application de l'invention. Par conséquent, les présents modes de réalisation doivent être considérés à titre d'illustration, et peuvent être modifiés sans toutefois sortir de la portée définie par les revendications.

## Revendications

1. Dispositif (10) de contrôle de la pérennité du réseau de terre contre la foudre **caractérisé en ce qu'**il comporte un câble (11) en acier galvanisé.

2. Dispositif selon la revendication 1, dans lequel le câble (11) a une section de 95 mm² plus ou moins les tolérances de fabrication et une longueur de 1,3 mètre plus ou moins 1 cm, la partie en contact avec le sol ayant une longueur de 1 mètre.

3. Dispositif (10) selon une des revendications 1 ou 2, dans lequel le câble (11) comporte un capuchon thermo-rétractable à chacune de ses extrémités.

4. Procédé de mise en place du dispositif (10) de contrôle de la pérennité du réseau de terre contre la foudre selon une des revendications 1 à 3, **caractérisé en ce qu'**il consiste à :
- déterminer (50) des zones de positionnement du dispositif (10) dans le sol,
- enfouir (60) le dispositif (10) dans le sol au niveau des zones déterminées.

5. Procédé selon la revendication 4, dans lequel la détermination des zones se fait par mesure du potentiel à courant coupé (Eoff) permettant de déterminer l'efficacité de la protection cathodique du réseau de terre.

6. Procédé selon une des revendications 4 ou 5, dans lequel les zones, d'installations des dispositifs (10), déterminées sont les suivantes :
- au moins une zone avec une protection cathodique satisfaisante avec un potentiel à courant coupé (Eoff) compris entre -900 mV et - 1500mV,
- au moins une zone à creux de potentiel, avec potentiel à courant coupé (Eoff) supérieur à -900 mV,
- au moins une zone à risque de surprotection cathodique, avec un potentiel à courant coupé (Eoff) inférieur à -1500mV.

7. Procédé selon une des revendications 4 à 6, dans lequel on détermine au moins deux zones à creux de potentiel.

8. Procédé selon une des revendications 4 à 7, dans lequel :
- on met en place le dispositif (10) à au moins 0,5 m du câble de terre (70),
- on soude un câble de protection cathodique sur le réseau de terre et sur le dispositif (10),
- sur chaque extrémité du dispositif (10) on dispose un capuchon thermo-rétractable (12, 13) pour obtenir une longueur effective de câble (11) en contact avec le sol de 1,00 m,
- On rétreint les capuchons thermo-rétractables avec une source de chaleur compatible avec le manchon,
- On pose un coffret (20) de mesure à proximité de la liaison du dispositif (10),
- On connecte les deux extrémités des câbles de protection cathodique sur une platine (21) sécurisée dans ce coffret (20) de mesure,
- On met des shunts de liaison sur la platine dans le coffret (20) entre le dispositif (10) et le réseau de terre afin de mettre sous protection cathodique le dispositif (10).
